# EUROPÄISCHE PATENTSCHRIFT

(11) **EP 2 501 517 B1**
(45) Veröffentlichungstag und Bekanntmachung des Hinweises auf die Patenterteilung: **06.03.2019**
(21) Anmeldenummer: 10782265.2
(22) Anmeldetag: 22.11.2010
(51) Int. Cl.: B23K 1/00, B23K 1/20, B32B 15/01, C22C 5/06, C22C 9/00, C22C 13/00, B23K 35/26, B23K 35/00, H01L 41/047, H01L 41/293

(54) **PIEZOELEKTRISCHES BAUELEMENT EIN LOTMATERIAL ZUR BEFESTIGUNG EINER AUSSENELEKTRODE ENTHALTEND**
PIEZOELECTRIC ELEMENT CONTAINING A SOLDER FOR BONDING AN EXTERNAL ELECTRODE
COMPSANT PIÉZOÉLECTRIQUE CONTENANT UN PRODUIT À BRASSER POUR BRASSER UN ÉLECTRODE EXTERNE

(30) Priorität: 20.11.2009 DE 102009054068
(43) Veröffentlichungstag der Anmeldung: 26.09.2012
(73) Patentinhaber: TDK Electronics AG, 81671 München (DE)
(72) Erfinder: RINNER, Franz, A-8530 Deutschlandsberg (AT); WEIGLHOFER, Markus, 8402 Werndorf (AT); OTTLINGER, Marion, A-8530 Deutschlandsberg (AT); GABL, Reinhard, 6330 Kufstein (AT); GALLER, Martin, A-8020 Graz (AT); AUER, Christoph, 8043 Graz (AT); KÜGERL, Georg, A-8552 Eibiswald (AT)
(74) Vertreter: Epping - Hermann - Fischer
(86) Internationale Anmeldenummer: PCT/EP2010/067942
(87) Internationale Veröffentlichungsnummer: WO 2011/061335

(56) Entgegenhaltungen:
- EP-A1- 0 844 678
- EP-A1- 1 048 392
- EP-A2- 1 080 823
- JP-A- 2004 304 025
- US-A1- 2008 070 059

## Beschreibung

Es wird ein piezoelektrisches Bauelement mit einem Lotmaterial zur Befestigung einer Außenelektrode angegeben. Ein derartiges Bauelement ist beispielsweise ein Piezoaktor, der zum Betätigen eines Einspritzventils in einem Kraftfahrzeug eingesetzt werden kann.

In der Druckschrift EP 0844678 B1 ist ein Piezoaktor angegeben, bei dem eine Außenelektrode an eine Grundmetallisierung angelötet ist. Die Druckschrift JP 2004304025 offenbart ein weiteres piezoelektrisches Bauelement mit verlöteten elektrischen Kontakten. Die Druckschrift US 2008/070059 A1 offenbart ein Lotmaterial zur Kontaktierung elektronischer Bauteile.

Es ist eine zu lösende Aufgabe, ein piezoelektrisches Bauelement mit einem Lotmaterial zur Befestigung einer Außenelektrode anzugeben, so dass eine möglichst zuverlässige und dauerhafte Befestigung der Außenelektrode erreicht werden kann.

Es wird ein piezoelektrisches Bauelement mit einem Lotmaterial zur Befestigung einer Außenelektrode angegeben. Das Lotmaterial enthält als Hauptbestandteil Zinn und einen Zusatz aus der Menge Kobalt, Kupfer und Silber. Durch die Verwendung eines derartigen Zinn-Lotes kann eine zuverlässige Anbindung einer Außenelektrode bei einem piezoelektrischen Bauelement erreicht werden. Dies ist in besonderem Maße bei einem piezoelektrischen Bauelement erforderlich, bei dem mechanische Spannungen zu einem Ablösen der Außenelektrode führen können.

Das Lotmaterial eignet sich zur Befestigung einer Außenelektrode. Ein Piezoaktor weist einen Grundkörper auf, der sich im Betrieb beim Anlegen einer elektrischen Spannung ausdehnt. Dabei können an der Außenseite des Grundkörpers mechanische Spannungen und Risse entstehen. Die Befestigung einer Außenelektrode am Grundkörper muss diesen Belastungen standhalten, so dass eine elektrische Kontaktierung des Bauelements sichergestellt ist.

Erfindungsgemäß ist der Piezoaktor in Vielschichtbauweise hergestellt. Der Grundkörper weist übereinander gestapelte piezoelektrische Schichten und dazwischen angeordnete Elektrodenschichten auf. Die piezoelektrischen Schichten sind beispielsweise aus einem keramischen Material und die Elektrodenschichten aus einer Kupferpaste, einer Silberpaste oder einer Silber-Palladium-Paste gebildet. Vorzugsweise werden die piezoelektrischen Schichten und die Elektrodenschichten gemeinsam gesintert und bilden somit einen monolithischen Sinterkörper.

Zur elektrischen Kontaktierung der Elektrodenschichten sind Grundmetallisierungen auf die Außenseite des Grundkörpers aufgebracht. Beispielsweise sind Grundmetallisierungen auf zwei gegenüberliegenden Seitenflächen des Grundköpers vorgesehen. Vorzugsweise reichen die Elektrodenschichten abwechselnd bis zu einer der Grundmetallisierungen heran und sind in Bezug auf die gegenüberliegende Grundmetallisierung in den Stapel zurückversetzt. Auf diese Weise kann mittels der Grundmetallisierungen eine elektrische Spannung zwischen benachbarte Elektrodenschichten angelegt werden.

Die Grundmetallisierungen sind aus eingebrannten Pasten gebildet, die als Hauptbestandteil Kupfer, Silber oder Silber-Palladium enthalten können. Zudem können die Pasten einen Glasflussanteil, beispielsweise in Form von Bleioxid oder Siliziumdioxid, enthalten, wodurch eine besonders stabile Anbindung an einen gesinterten Grundkörper hergestellt werden kann.

In einer Ausführungsform ist das Lotmaterial derart zusammengesetzt, dass es zuverlässig an einer Grundmetallisierung haftet und keine oder nur eine geringe Ablegierung der Grundmetallisierung hervorruft. In diesem Fall kann das Lotmaterial direkt auf die Grundmetallisierung aufgebracht werden. Durch den angegebenen Zusatz an dem geeigneten, hochschmelzenden Metall Kobalt sollen Diffusionsprozesse im Lotmaterial verlangsamt werden. Der Zusatz kann Kristallisationskeime beim Erstarren des Lotmaterials bereitstellen und so zu einem feinkörnigen Gefüge führen. Auf diese Weise kann insbesondere die Diffusion des Zinns in Richtung der Grundmetallisierung und eine chemische Reaktion des Zinns mit dem Material der Grundmetallisierung vermieden werden.

Erfindungsgemäß enthält das Lotmaterial einen Zusatz von Kobalt. Es hat sich herausgestellt, dass durch eine Verwendung von Kobalt eine besonders zuverlässige Anbindung des Lotmaterials erreicht werden kann.

Der Anteil des Zusatzes beträgt zwischen 0,03 Gew.-% und 0,17 Gew.-%.

Das Lotmaterial enthält als weitere Zusätze Silber und Kupfer. Durch derartige Zusätze können der Schmelzpunkt des Lotmaterials, die Sprödigkeit und die Benetzungseigenschaften eingestellt werden.

Weiterhin weist das verwendete Lotmaterial eine hohe Temperaturstabilität auf. Die Temperaturstabilität kann beispielsweise durch die Zusätze Silber und Kupfer eingestellt werden.

Das Lotmaterial enthält einen Zusatz von Silber in einem Anteil zwischen 2,5 Gew.-% und 3,5 Gew.-%. Zusätzlich enthält das Lotmaterial einen Zusatz von Kupfer in einem Anteil zwischen 0,3 Gew.-% und 0,7 Gew.-%.

Ein erfindungsgemäßes Lotmaterial enthält als Hauptbestandteil Zinn, einen Zusatz von Silber in einem Anteil zwischen 2,5 Gew.-% und 3,5 Gew.-%, einen Zusatz von Kupfer in einem Anteil zwischen 0,3 Gew.-% und 0,7 Gew.-% und einen Zusatz von Kobalt in einem Anteil zwischen 0,03 Gew.-% und 0,17 Gew.-%. Beispielsweise wird ein SnAg3Cu0,5Co0,1-Lotmaterial verwendet, bei dem der Sollwert von Silber bei 3,0 Gew.-%, der Sollwert von Kupfer bei 0,5 Gew.-%, der Sollwert von Kobalt bei 0,1 Gew.-% liegt und der Rest des Materials von Zinn gebildet wird.

Vorzugsweise ist das Lotmaterial bleifrei. Insbesondere sollte es der so genannten RoHS-Richtlinie der Europäischen Union zur Beschränkung der Verwendung bestimmter gefährlicher Stoffe in Elektro- und Elektronikgeräten genügen.

Das erfindungsgemäße piezoelektrische Bauelement weist einen Grundkörper aus piezoelektrischen Schichten und dazwischen angeordneten Elektrodenschichten auf. Auf wenigstens eine Außenseite des Grundkörpers ist eine Grundmetallisierung aufgebracht. Das Lotmaterial ist über der Grundmetallisierung aufgebracht.

Vorzugsweise ist mittels des Lotmaterials eine Außenelektrode am Grundkörper des Bauelements befestigt. Beispielsweise ist die Außenelektrode als Drahtgewebe ausgebildet. In einer weiteren Ausführungsform ist die Außenelektrode als sogenannte Drahtharfe ausgebildet, bei der parallel angeordnete Drähte am Grundkörper befestigt sind und zu einer Weiterkontaktierung führen, die vom Grundkörper beabstandet angeordnet ist.

In einer Ausführungsform ist das Lotmaterial direkt auf die Grundmetallisierung aufgebracht. Dies ermöglicht eine besonders kostengünstige Herstellung des Bauelements.

In einer alternativen Ausführungsform ist auf die Grundmetallisierung eine Beschichtung aufgebracht, die vorzugsweise die Benetzung des Lotmaterials verbessert. Das Lotmaterial ist auf die Beschichtung aufgebracht. Auf diese Weise kann eine besonders zuverlässige Lotverbindung hergestellt werden.

Eine derartige Beschichtung kann mittels eines Sputterprozesses auf die Grundmetallisierung aufgebracht sein. Die Beschichtung enthält beispielsweise Metalle aus der Menge Silber, Nickel, Chrom oder Kupfer.

Zur Befestigung einer Außenelektrode am Grundkörper wird die Außenelektrode auf die Grundmetallisierung oder auf eine Beschichtung auf der Grundmetallisierung aufgelegt. Beispielsweise ist die Außenelektrode mit dem Lotmaterial beschichtet. Nach dem Auflegen der Außenelektrode auf den Grundkörper wird das Lotmaterial erhitzt, sodass es erweicht und eine stoffschlüssige Verbindung mit der Grundmetallisierung oder der Beschichtung eingeht. Vorzugsweise wird die Außenelektrode während des Lötprozesses an die Grundmetallisierung angedrückt, um eine platzsparende und zuverlässige Verlötung zu erreichen.

Im Folgenden werden das angegebene Bauelement und mögliche Verwendungen des Lotmaterials anhand von schematischen und nicht maßstabsgetreuen Figuren erläutert. Es zeigen:
- Figur 1: einen Querschnitt eines piezoelektrischen Bauelements mit einer Außenelektrode in Form eines Drahtgewebes,
- Figur 2: einen Querschnitt eines piezoelektrischen Bauelements mit einer Außenelektrode in Form einer Drahtharfe,
- Figur 3: im Querschnitt eine erste Ausführungsform einer Befestigung einer Außenelektrode bei einem piezoelektrischen Bauelement,
- Figur 4: im Querschnitt eine zweite Ausführungsform einer Befestigung einer Außenelektrode bei einem piezoelektrischen Bauelement.

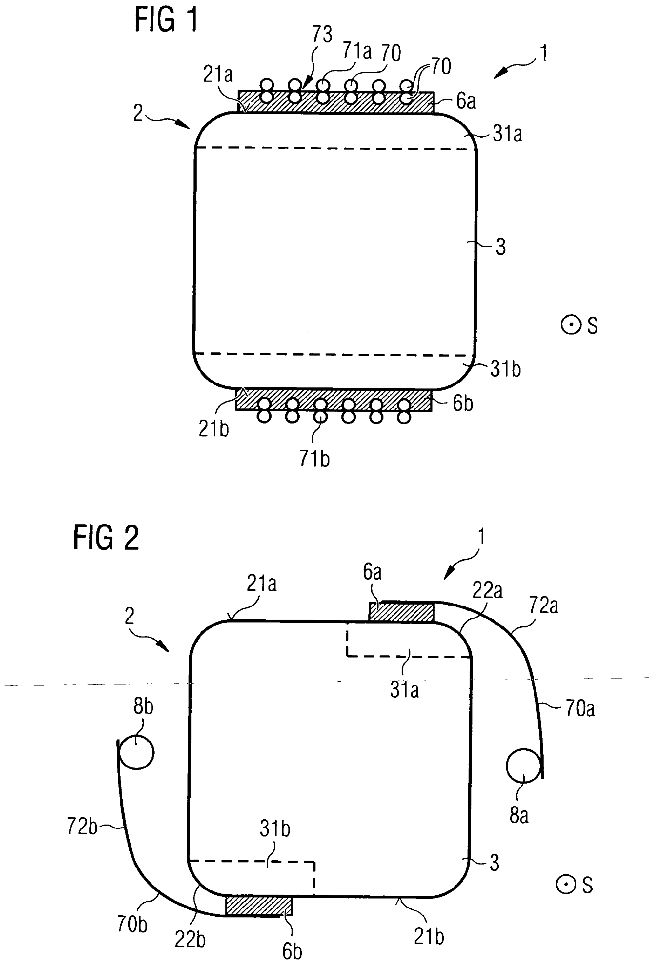

Figur 1 zeigt einen Querschnitt eines piezoelektrischen Bauelements 1 in Form eines Piezoaktors. Das Bauelement 1 weist einen Grundkörper 2 aus übereinander gestapelten piezoelektrischen Schichten 3 und Elektrodenschichten (hier nicht zu sehen) auf. Die piezoelektrischen Schichten 3 und Elektrodenschichten sind entlang einer Stapelrichtung S übereinander gestapelt und gemeinsam gesintert. Der Grundkörper 2 weist eine Längsachse auf, die der Stapelrichtung S entspricht.

Für die Herstellung der piezoelektrischen Schichten 3 werden beispielsweise dünne Folien aus einem piezokeramischen Material, wie Blei-Zirkonat-Titanat (PZT), verwendet. Zur Bildung der Elektrodenschichten kann in einem Siebdruckverfahren eine Metallpaste, z. B. eine Kupferpaste, Silberpaste oder eine Silber-Palladium-Paste, auf die Folien aufgebracht werden. Die Folien werden anschließend gestapelt, verpresst und gemeinsam gesintert.

Die Elektrodenschichten reichen entlang der Stapelrichtung S abwechselnd bis zu einer Außenseite 21a, 21b des Grundkörpers 2 und sind von der anderen Außenseite 21b, 21a beabstandet. Auf diese Weise entstehen im Grundkörper 2 so genannte inaktive Zonen 31a, 31b, in denen sich in Stapelrichtung S benachbarte Elektrodenschichten unterschiedlicher Polarität nicht überlappen. In den inaktiven Zonen 31a, 31b findet beim Anlegen einer elektrischen Spannung nur eine geringe oder überhaupt keine Ausdehnung des Bauelements 1 statt.

Auf gegenüber liegenden Außenseiten 21a, 21b des Grundkörpers 2 sind angrenzend an die inaktiven Zonen 31a, 31b Außenelektroden in Form von Drahtgeweben 71a, 71b aufgebracht. Die Drahtgewebe 71a, 71b sind jeweils mittels eines Lotmaterials 6a, 6b an einer Grundmetallisierung (hier nicht zu dargestellt) an der Außenseite 21a, 21b des Grundkörpers 2 befestigt.

Die Drahtgewebe 71a, 71b umfassen eine Vielzahl von miteinander verwebten Drähten 70, die in Winkeln von 45° zur Stapelrichtung S verlaufen. Die Drähte 70 weisen als Grundmaterial Stahl auf und sind mit einer KupferBeschichtung versehen. In der gezeigten Schnittansicht sind Kreuzungspunkte 73 zu sehen, an denen sich die Drähte 70 in einem Winkel von 90° überschneiden.

Im hier gezeigten Ausführungsbeispiel ist das Drahtgewebe 71a, 71b vollflächig mit der Grundmetallisierung 4 verlötet. Dies bedeutet, dass sich auf allen Drahtabschnitten des Drahtgewebes 71a, 71b zumindest bereichsweise Lotmaterial 6a, 6b befindet, welches die Anbindung an die Grundmetallisierung 4 herstellt. Insbesondere befindet sich das Lotmaterial 6a, 6b zumindest auf Teilbereichen der Drahtabschnitte, die der Grundmetallisierung 4 zugewandt sind.

Das Lotmaterial 6a, 6b enthält als Hauptbestandteil Zinn und einen Zusatz von Kobalt. Weiterhin enthält das Lotmaterial 6a, 6b neben dem Hauptbestandteil Zinn einen Zusatz von Silber in einem Anteil zwischen 2,5 Gew.-% und 3,5 Gew.-%, einen Zusatz von Kupfer in einem Anteil von 0,3 Gew.-% und 0,7 Gew.-% und einen Zusatz von Kobalt im Anteil von 0,03 Gew.-% bis 0,17 Gew.-%.

Durch derartige Zusätze lässt sich ein Ablegieren der Grundmetallisierung durch das Lotmaterial 6a, 6b verringern. Insbesondere kann die Diffusion des Zinns zur Grundmetallisierung hin verlangsamt und so eine Reaktion des Zinns mit der Grundmetallisierung verhindert werden. Zudem lässt sich eine zuverlässige Haftung des Lotmaterials 6a, 6b an der Grundmetallisierung erreichen.

Figur 2 zeigt eine weitere Ausführungsform für eine Außenelektrode bei einem piezoelektrischen Bauelement 1 in Form eines Piezoaktors.

Der Grundkörper 2 weist übereinander gestapelte piezoelektrische Schichten 3 und Elektrodenschichten (hier nicht zu sehen) auf. Die Elektrodenschichten sind abwechselnd bis zu einer Kante 22a, 22b des Grundkörpers 2 geführt und von der diagonal gegenüberliegenden Kante 22b, 22a beabstandet, so dass sich die inaktiven Zonen 31a, 31b im Bereich der gegenüberliegenden Kanten 22a, 22b befinden. Zur elektrischen Kontaktierung der Innenelektroden sind auf zwei gegenüberliegenden Außenseiten 21a, 21b, angrenzend an die inaktiven Zonen 22a, 22b, Grundmetallisierungen (hier nicht zu sehen) aufgebracht. Die Grundmetallisierungen erstrecken sich in Form von schmalen Streifen entlang der Stapelrichtung S des Grundkörpers 2.

Über jeder Grundmetallisierung ist ein Lotmaterial 6a, 6b aufgebracht, mittels dem Außenelektroden in Form von Drahtharfen 72a, 72b am Grundkörper 2 befestigt sind. Jede der Drahtharfen 72a, 72b weist eine Vielzahl von parallel verlaufenden Drähten 70a, 70b auf, die um eine Kante 22a, 22b des Grundkörpers 2 herumgeführt sind. An ihren freien Enden sind die Drahtharfen 72a, 72b mit Weiterkontaktierungen in Form von Kontaktpins 8a, 8b verbunden.

Das Lotmaterial 6a, 6b weist als Hauptbestandteil Zinn und wenigstens einen Zusatz aus der Menge Kobalt, Silber und Kupfer auf.

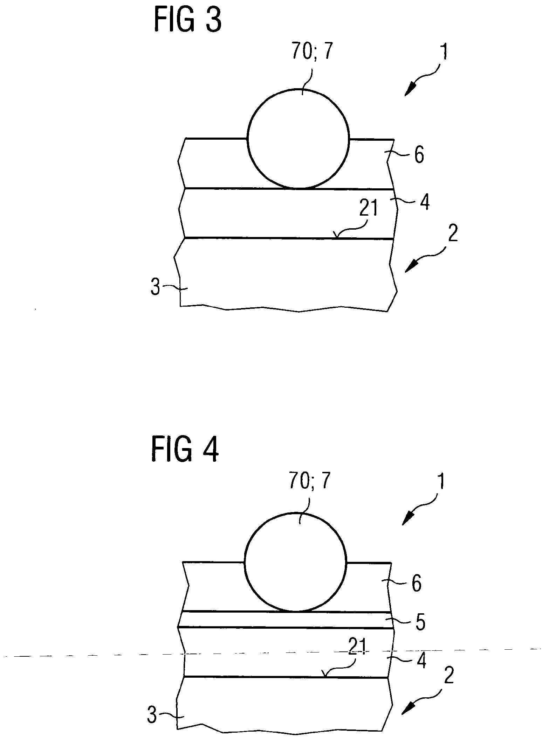

Figur 3 zeigt im Detail eine erste Ausführungsform für die Befestigung einer Außenelektrode 7 bei einem piezoelektrischen Bauelement 1. Das Bauelement 1 ist ein Piezoaktor, wie er beispielsweise in den Figuren 1 oder 2 gezeigt ist.

Am Grundkörper 2 des Bauelements 1 ist eine Außenelektrode 7 befestigt, die eine Vielzahl von Drähten 70 aufweist. Die Außenelektrode 7 kann beispielsweise als Drahtgewebe 71a, 71b, wie in Figur 1 gezeigt, oder als Drahtharfe 72a, 72b, wie in Figur 2 gezeigt, ausgebildet sein.

Auf die Außenseite 21 des Grundkörpers 2 ist eine Grundmetallisierung 4 aufgebracht. Die Grundmetallisierung 4 wird aus einer eingebrannten Kupferpaste gebildet, die einen Glasflussanteil enthält. Durch eine teilweise Eindiffusion des Glasflussanteils in die piezoelektrischen Schichten 3 und die Elektrodenschichten kann eine besonders feste Verbindung mit dem Grundkörper 2 erreicht werden. Die Grundmetallisierung 4 weist beispielsweise eine Dicke im Bereich von 20 bis 50 µm auf.

Die Drähte 70 der Außenelektrode 7 sind mittels des Lotmaterials 6 an der Grundmetallisierung 4 befestigt. Das Lotmaterial 6 ist über der Grundmetallisierung 4 aufgetragen und grenzt unmittelbar an die Grundmetallisierung 4 an. Bei der Befestigung der Außenelektrode 7 am Grundkörper 2 werden die Drähte 70 an den Grundkörper 2 angedrückt. Auf diese Weise kann eine besonders zuverlässige Befestigung der Drähte 70 erreicht werden. Die Drähte 70 liegen dadurch zumindest teilweise direkt auf der Grundmetallisierung 4 auf und sind in seitlichen Bereichen von Lotmaterial 6 bedeckt. In einer Ausführungsform ist auf alle Drahtabschnitte der Drähte 70 Lotmaterial 6 wenigstens in einem der Grundmetallisierung 4 zugewandten Teilbereich aufgebracht, wodurch eine vollflächige Befestigung der Drähte 70 an der Grundmetallisierung hergestellt wird.

In einer weiteren Ausführungsform kann auf die Grundmetallisierung eine durchgängige Lotschicht aufgebracht sein. In diesem Fall stehen die Drähte in keinem direkten Kontakt mit der Grundmetallisierung.

In einer weiteren Ausführungsform heben die Drähte bereichsweise von der Grundmetallisierung ab und es befindet sich ein nicht mit Lotmaterial gefüllter Zwischenraum zwischen den Drähten und der Grundmetallisierung. Auf diese Weise kann die Dehnbarkeit der Außenelektrode erhöht werden.

Figur 4 zeigt eine weitere Ausführungsform für eine Befestigung einer Außenelektrode 7 bei einem piezoelektrischen Bauelement 1.

Hier ist auf die Grundmetallisierung 4 eine durchgängige Beschichtung 5 aufgebracht. Die Außenelektrode 7 ist mittels des Lotmaterials 6 an der Beschichtung 5 befestigt. Die Beschichtung 5 ist zum Beispiel eine Sputterschicht aus Silber, Nickel, Chrom oder Kupfer und weist eine Dicke im Bereich von 0,1 µm bis 1 µm, beispielsweise von 0,3 µm auf.

Die Beschichtung 5 weist eine besonders gute Lötbarkeit auf, so dass das Lotmaterial 6 sehr zuverlässig an der Beschichtung 5 befestigt werden kann.

Bei der Befestigung der Außenelektrode 7 am Grundkörper 2 wird beispielsweise auf den Grundköper 2 eine Grundmetallisierung 4, zum Beispiel eine Kupferpaste oder eine Silber-Palladium-Paste, aufgebracht und eingebrannt. Anschließend wird eine Beschichtung 5 mittels eines Sputterprozesses auf die Grundmetallisierung 4 aufgebracht. Die Außenelektrode 7 wird auf die Beschichtung 5 aufgelegt und angelötet.

### Bezugszeichenliste

- 1: piezoelektrisches Bauelement
- 2: Grundkörper
- 21, 21a, 21b: Außenseite
- 22a, 22b: Kante
- 3: piezoelektrische Schicht
- 31a, 31b: inaktive Zone
- 4: Grundmetallisierung
- 5: Beschichtung
- 6: Lotmaterial
- 70, 70a, 70b: Draht
- 71, 71a, 71b: Drahtgewebe
- 72, 72a, 72b: Drahtharfe
- 73: Kreuzungspunkt
- 8a, 8b: Kontaktpin

- S: Stapelrichtung

## Patentansprüche

1. Piezoelektrisches Bauelement
- mit einem Grundkörper (2) aus piezoelektrischen Schichten (3) und dazwischen angeordneten Elektrodenschichten und
- mit einer Grundmetallisierung (4), die auf eine Außenseite (21, 21a, 21b) des Grundkörpers (2) aufgebracht ist,
- bei dem ein Lotmaterial (6, 6a, 6b) zur Befestigung einer Außenelektrode über der Grundmetallisierung (4) aufgebracht ist und
- bei dem das Lotmaterial (6, 6a, 6b) als Hauptbestandteil Zinn und einen Zusatz von Silber in einem Anteil zwischen 2,5 Gew.-% und 3,5 Gew.-%, einen Zusatz von Kupfer in einem Anteil zwischen 0,3 Gew.-% und 0,7 Gew.-% und einen Zusatz von Kobalt in einem Anteil zwischen 0,03 Gew.-% und 0,17 Gew.-%enthält,
- bei dem die Grundmetallisierung (4) aus einer eingebrannten Paste gebildet ist,
- bei dem die eingebrannte Paste als Hauptbestandteil ein Metall aus der Menge Kupfer, Silber und Silber-Palladium aufweist.

2. Piezoelektrisches Bauelement nach Anspruch 1,
- bei dem das Lotmaterial (6, 6a, 6b) direkt auf die Grundmetallisierung (4) aufgebracht ist.

3. Piezoelektrisches Bauelement nach Anspruch 1,
- bei dem eine Beschichtung (5) auf die Grundmetallisierung (4) aufgebracht ist und bei dem das Lotmaterial (6, 6a, 6b) auf die Beschichtung (5) aufgebracht ist.

4. Piezoelektrisches Bauelement nach einem der Ansprüche 1 bis 3
- mit einer Außenelektrode (7, 71a, 71b), die als Drahtgewebe (71a, 71b) ausgebildet ist.

## Claims

1. Piezoelectric component
- with a main body (2) from piezoelectric layers (3) and electrode layers arranged in between and
- with a base metallization (4), which is applied to an outer side (21, 21a, 21b) of the main body (2),
- in which a solder material (6, 6a, 6b) for fastening an outer electrode is applied over the base metallization (4) and
- in which the solder material (6, 6a, 6b) contains tin as the main constituent and an addition of silver in a proportion of between 2.5% by weight and 3.5% by weight, an addition of copper in a proportion of between 0.3% by weight and 0.7% by weight and an addition of cobalt in a proportion of between 0.03% by weight and 0.17% by weight,
- in which the base metallization (4) is formed from a fired paste,
- in which the fired paste comprises as the main constituent a metal from the group consisting of copper, silver and silver-palladium.

2. Piezoelectric component according to Claim 1,
- in which the solder material (6, 6a, 6b) is applied directly onto the base metallization (4).

3. Piezoelectric component according to Claim 1,
- in which a coating (5) is applied onto the base metallization (4) and in which the solder material (6, 6a, 6b) is applied onto the coating (5).

4. Piezoelectric component according to one of Claims 1 to 3,
- with an outer electrode (7, 71a, 71b), which is formed as a wire mesh (71a, 71b).

## Revendications

1. Composant piézoélectrique,
- comprenant un corps de base (2) composé de couches piézoélectriques (3) et de couches d'électrode disposées entre celles-ci et
- comprenant une métallisation de base (4) qui est appliquée sur un côté extérieur (21, 21a, 21b) du corps de base (2),
- dans lequel un matériau de brasage (6, 6a, 6b) destiné à la fixation d'une électrode externe est appliqué sur la métallisation de base (4) et
- dans lequel le matériau de brasage (6, 6a, 6b) contient comme élément constitutif principal de l'étain et un apport d'argent dans une proportion comprise entre 2,5 % massiques et 3,5 % massiques, un apport de cuivre dans une proportion comprise entre 0,3 % massique et 0,7 % massique et un apport de cobalt dans une proportion comprise entre 0,03 % massique et 0,17 % massique,
- avec lequel la métallisation de base (4) est formée à partir d'une pâte cuite,
- dans lequel la pâte cuite possède comme élément constitutif principal un métal du groupe cuivre, argent et argent-palladium.

2. Composant piézoélectrique selon la revendication 1,
- avec lequel le matériau de brasage (6, 6a, 6b) est appliqué directement sur la métallisation de base (4).

3. Composant piézoélectrique selon la revendication 1,
- avec lequel un revêtement (5) est appliqué sur la métallisation de base (4) et avec lequel le matériau de brasage (6, 6a, 6b) est appliqué sur le revêtement (5).

4. Composant piézoélectrique selon l'une des revendications 1 à 3,
- comprenant une électrode externe (7, 71a, 71b) qui est réalisée sous la forme d'une toile métallique (71a, 71b).
